**Europäisches Patentamt**

**European Patent Office**

**Office européen des brevets**

(19)

(11) Veröffentlichungsnummer: **0 037 882**
**B1**

(12) **EUROPÄISCHE PATENTSCHRIFT**

(45) Veröffentlichungstag der Patentschrift:
08.08.84

(21) Anmeldenummer: 81101038.8

(22) Anmeldetag: 14.02.81

(51) Int. Cl.³: **H 04 Q 3/00,** H 04 Q 3/52,
H 04 Q 1/16, H 05 K 1/02

(54) **Mehrstufiges Koppelfeld.**

(30) Priorität: 14.04.80 DE 3014265
16.04.80 DE 3014562

(43) Veröffentlichungstag der Anmeldung:
21.10.81 Patentblatt 81/42

(45) Bekanntmachung des Hinweises auf die Patenterteilung:
08.08.84 Patentblatt 84/32

(84) Benannte Vertragsstaaten:
AT CH DE FR IT LI

(56) Entgegenhaltungen:
DE - A - 2 500 939
DE - C - 1 269 651
FR - A - 2 109 246
FR - A - 2 158 677
GB - A - 2 025 736

NACHRICHTENTECHN. ZEITSCHRIFT, Band 29, Nr. 10,
Oktober 1976, Seiten 756-761 Berlin, DE. H. KLIEM:
"Eine Breitbandkoppelanordnung mit integrierten
elektronischen Koppelpunkten"

(73) Patentinhaber: GRUNDIG E.M.V. Elektro-Mechanische
Versuchsanstalt Max Grundig & Co. KG.,
Kurgartenstrasse 37, D-8510 Fürth (DE)

(72) Erfinder: Boenisch, Werner, Dipl.-Ing., Ronhofer Weg 39,
D-8510 Fuerth (DE)
Erfinder: Berk, Gerhard, Ing. grad., Kirchenweg 28,
D-8501 Oberasbach (DE)
Erfinder: Fleissner, Horst, Ing. grad., Glogauer Strasse,
D-8506 Langenzenn (DE)

## Beschreibung

Die Erfindung bezieht sich auf ein mehrstufiges Koppelfeld, insbesondere zur Verkopplung höherfrequenter Signalquellen und -senken gemäß Oberbegriff des Anspruchs 1.

Mehrstufige Koppelfelder finden dann Verwendung, wenn eine Vielzahl von Signalquellen mit einer Vielzahl von Signalsenken verkoppelbar sein müssen. Bei einstufigen Koppelfeldern ist die notwendige Anzahl der Koppelpunkte gleich dem Produkt aus der Anzahl Quellen und der Anzahl Senken. Es ist jedoch wenig sinnvoll, diese Verbindungsart für große Kreuzschaltfelder anzuwenden, weil in der Praxis nur relativ wenige Kreuzungspunkte gleichzeitig gesetzt werden.

Für beispielsweise 100 Quellen und 150 Verbraucher werden bei einem einstufigen Koppelfeld 15 000 Koppelpunkte benötigt. Aus Betriebsgründen können jedoch nur max. 150 Kreuzungspunkte gesetzt sein, was einem prozentualen Verhältnis von nur einem Prozent entspricht. Durch Verwendung mehrstufiger Koppelfelder kann die Anzahl der erforderlichen Koppelpunkte ganz erheblich reduziert werden. Außerdem bieten mehrstufige Felder im Gegensatz zu einstufigen den Vorteil, daß bei Ausfall eines Koppelpunktes eine Umgehungsschaltung möglich ist, sofern das Koppelfeld nur teilausgelastet ist.

Nachteil mehrstufiger Koppelfelder ist, daß in n-stufigen Koppelfeldern natürlich jeweils n Koppelpunkte hintereinander geschaltet sind. Hieraus resultieren jedoch keine ernsthaften Probleme. In einem Fernsehstudio beispielsweise kann ein elektronischer Prozeßrechner, der einen täglichen Sende- und Produktionsfahrplan enthält, über ein »Wegesuch-Programm« den gesamten Betriebsablauf optimieren. Bei Ausfall eines Koppelpunktes kann unter den oben geschilderten Umständen automatisch eine Umgehungsschaltung hergestellt werden.

Die bisher bekannten mehrstufigen Koppelfelder (NTZ, 1965, Heft 10, Seiten 593—97; Fernseh- und Kino-Technik, 32. Jg., Nr. 10/1978, Seiten 383—387 weisen zwischen den einzelnen Stufen des Koppelfeldes Verkabelungen auf. Dies erfordert einmal einen relativ hohen Arbeitsaufwand bei der Herstellung der Verbindung zwischen den einzelnen Stufen und widerspricht dem insbesondere für höherfrequente Signale anzustrebenden Ziel, kürzestmögliche Verbindungen zwischen den Teilkoppelfeldern der einzelnen Stufen herzustellen.

Das GRUNDIG-Koppelfeld VAK 71 ist flächig aufgebaut. Es ist jedoch nicht aus einzelnen Moduln zusammengesetzt und benötigt zur Steuerung eines jeden Koppelpunktes eine Steuerleitung von einem separat untergebrachten Steuerteil.

Bei dem aus einzelnen Moduln für je eine Ausgangsachse aufgebauten Koppelfeld Telefunken Telkos besitzen die einzelnen Moduln je eine eigene Steuerlogik. Mehrere Moduln stehen aber flächenparallel in Einschüben nebeneinander und müssen untereinander wie auch mit weiteren Einschüben durch Kabelbäume verbunden werden.

Aus der FR-A-2 109 246 ist ein Verfahren zur Verbindung einzelner Stufen in einem Koppelfeld bekannt, das einen relativ großen Raumbedarf erfordert und geringe Flexibilität aufweist. Bei diesem bekannten Koppelfeld sind auch lange Leitungswege mit dem Nachteil höherer Signallaufzeiten und eine schlechte Übersprechdämpfung gegeben, und die vorgesehenen Platten müssen jeweils für einen maximalen auslegbaren Aufbau vorgesehen werden, d. h. ein kleines Koppelfeld muß den gleichen Aufbau wie ein großes Koppelfeld haben, es ist lediglich weniger bestückt. Darüber hinaus wird lediglich eine zweistufige Koppelfeldanordnung beschrieben, deren Aufbau nicht beliebig groß gestaltet werden kann und bei der viele Steckkontakte ungünstig untergebracht werden können. Darüber hinaus ist die dortige direkte Steckverbindung mittels starrer Kontakte ungünstig, da diese sich verbiegen können oder hohe Druck- und Zugkräfte auftreten, so daß ein derartiger Aufbau nur bei kleinen Einheiten möglich wird; d. h., die starre Verbindung begrenzt die Ausweitung des Teilfeldes bzw. einen größeren Ausbau. Auch ist bei vielen Steckkontakten ein hohes Maß an Justierarbeit erforderlich.

Die DE-PS 1 269 651 beschreibt eine elektronische Schaltermatrix als Koppelnetzwerk, welche insbesondere für Fernsprechvermittlungsanlagen — also für niederfrequente Signale — vorgesehen ist. Dabei sind an den Kreuzungspunkten der vertikal und horizontal angeordneten Leiter Dioden zur Herstellung von elektrischen Verbindungen vorgesehen, wobei die Koppelpunktdurchschaltung unklar ist und auch bei einem dreistufigen Ausbau Probleme entstehen, da Kontakte an zwei Seiten auftreten und die verwendete Platte nicht ohne weiteres entnehmbar ist. Der Aufbau dieses bekannten Koppelnetzwerks ergibt einen beschränkten Einsatzbereich, da nur eine Matrixdurchschaltung möglich ist und keine Möglichkeit erkennbar ist, nur einen Koppelpunkt durchzuschalten; darüber hinaus ist er ungünstig bezüglich der Übersprechdämpfung

Die DE-OS 2 500 939 beschreibt ein Kreuzschaltfeld, bei dem die Koppelpunkte einer Spalte und deren Ansteuerung auf einer Schaltungsplatine zu einer Einheit, sogenannten Spaltenmoduln zusammengefaßt sind, wobei durch die Verwendung von Spaltenmoduln eine einfache Vergrößerung des Kreuzschaltfeldes vorgenommen werden kann. Diese Offenlegungsschrift beschreibt insofern ein als Steckkartensystem aufgebautes Audio-Koppelfeld, bei dem die durch Schalter gebildeten Koppelpunkte zum wahlweisen Verbinden von Signalquellen mit Verbrauchern entsprechend der gewünschten Verbindung mit Ansteuerimpulsen über Speicher durchgeschaltet und im durchgeschalteten Zustand gehalten werden.

Der Erfindung liegt die Aufgabe zugrunde, ein mehrstufiges Koppelfeld zu schaffen, das möglichst kurze Verbindungen zwischen den Teilkoppelfeldern der einzelnen Stufen bei leichter Austauschbarkeit der Teilkoppelfelder einer Stufe sowie der Module in einem Teilkoppelfeld ermöglicht, wobei eine gute Übersprechdämpfung, insbesondere bei hohen Frequenzen, gegeben sein soll und jeder Koppelpunkt einzeln und unabhängig voneinander durchgeschaltet werden soll.

Diese Aufgabe wird erfindungsgemäß durch die im kennzeichnenden Teil des Anspruchs 1 angegebenen Maßnahmen gelöst.

Vorteilhafte Weiterbildungen ergeben sich aus den Unteransprüchen. Der Aufbau des erfindungsgemäßen Koppelfeldes kann so erfolgen, daß die Signallaufzeiten auf unterschiedlichen Wegen durch das gesamte Koppelfeld praktisch gleich sind. Insbesondere laufen bei einem beispielsweise dreidimensionalen Koppelfeld die Signale von einer Ecke diametral zur anderen Ecke, d. h. egal auf welchem Wege das Koppelfeld durchlaufen wird, die Summe bzw. Weglänge ist immer gleich, was gleiche Signallaufzeiten bewirkt und wichtig ist für Videosignale, wobei der Signallauf auf den unterschiedlichen Wegen von einer Eingangsstelle und anschließender Verteilung auf die einzelnen Punkte immer entlang der Hauptachsen und nur in Vorwärtsrichtung vom einen Eckpunkt diametral zum anderen Eckpunkt der Gesamtanordnung erfolgt.

Die Anwendungsmöglichkeit des erfindungsgemäßen Koppelfeldes erstreckt sich von Niederfrequenz bis über den Bereich der Videofrequenz hinaus. Das erfindungsgemäße Koppelfeld erlaubt ferner eine wahlfreie und unabhängige Durchschaltung und dank des platzsparenden Modulaufbaus eine leichte Erweiterbarkeit des ganzen Koppelfeldes bei hoher Sperrdämpfung, d. h. eine Vergrößerung der Anzahl an Quellen oder Senken. Dank schwimmender Steckverbindungen sind sehr viele Leitungen verbindbar und keine großen Steckkräfte etc. notwendig, während es der besondere Mechanismus ermöglicht, die Teilkoppelfelder einfach zu entfernen, deren beide Steckrichtungen einen rechten Winkel zueinander bilden und die Teilkoppelfelder — ohne eine Codierung ändern zu müssen — leicht austauschbar sind, da erfindungsgemäß die Information zur Auswahl eines Teilkoppelfeldes im Paket nicht im Teilkoppelfeld selbst, sondern im zugehörigen Steckplatz enthalten ist.

Die Erfindung wird nachfolgend unter Bezugnahme auf die Zeichnungsfiguren beispielsweise erläutert. Es zeigt

Fig. 1 eine schematische Darstellung der Verknüpfung zwischen einem Teilkoppelfeld einer ersten Stufe mit den Teilkoppelfeldern der nachfolgenden Stufe,

Fig. 2 die räumliche Zuordnung der parallel zueinander angeordneten Teilkoppelfelder der ersten Stufe zu den parallel zueinander angeordneten Teilkoppelfeldern der zweiten Stufe,

Fig. 3 eine schematische Darstellung der Verkopplung der jeweils ersten Ausgänge der Teilkoppelfelder der ersten Stufe mit den Eingängen eines Koppelfeldes der zweiten Stufe,

Fig. 4 eine Darstellung der räumlichen Anordnung der parallel zueinander angeordneten Teilkoppelfelder der ersten Stufe zu den parallel zueinander angeordneten Teilkoppelfeldern der zweiten Stufe und

Fig. 5 eine perspektivische Explosionsdarstellung, aus der die räumliche Zuordnung der einzelnen Stufen des Koppelfeldes ersichtlich ist,

Fig. 6 den prinzipiellen Aufbau eines Modul-Bausteins mit fünf Eingangs- und fünf Ausgangsleitungen,

Fig. 7 eine schematische Darstellung der Verbindung eines Steuermoduls mit einzelnen Koppelmoduln,

Fig. 8 eine schematische Darstellung eines Koppelmoduls mit fünf Eingangs- und fünf Ausgangssammelleitungen, einem Modul-Decoder »1 aus n« sowie je einem n-fach-D-Flip-Flop für je eine Ausgangssammelleitung,

Fig. 9 eine schematische Darstellung der Steckverbindungen zwischen den einzelnen Teilkoppelfeldern und

Fig. 10 ein Flachkabel mit Abschirmung.

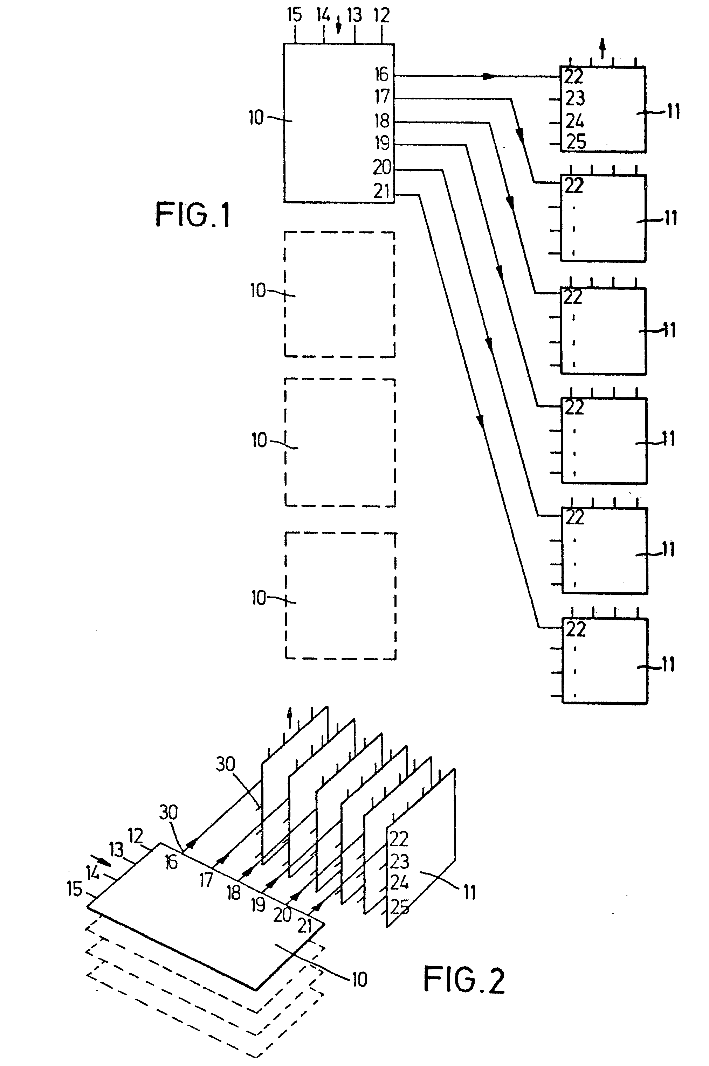

In Fig. 1 sind zwei Stufen eines mehrstufigen Koppelfeldes dargestellt. Die erste Stufe des Koppelfeldes besteht aus vier parallel zueinander angeordneten Teilkoppelfeldern 10. Die zweite Stufe besteht aus sechs parallel zueinander angeordneten Teilkoppelfeldern 11. Jedes rechteckige Teilkoppelfeld 10 der ersten Stufe weist an einer Schmalseite vier Eingänge 12 bis 15 und an einer Längsseite sechs Ausgänge 16 bis 21 auf.

Jedes Teilkoppelfeld 11 der zweiten Stufe weist vier Eingänge 22 bis 25 auf. Der erste Ausgang 16 des Teilkoppelfeldes 10 ist mit dem ersten Eingang 22 des ersten Teilkoppelfeldes 11 verbunden, der zweite Ausgang 17 des Teilkoppelfeldes 10 ist mit dem ersten Eingang 22 des zweiten Teilkoppelfeldes 11 verbunden usw. Insgesamt ist jeder Ausgang der Teilkoppelfelder 10 der ersten Stufe mit einem bestimmten Eingang eines der Teilkoppelfelder 11 der zweiten Stufe verbunden.

Die in der schematischen Darstellung gemäß Fig. 1 recht langen Verbindungswege zwischen den Ausgängen 16 bis 21 der Teilkoppelfelder 10 und den Eingängen 22 bis 25 der zugehörigen Teilkoppelfelder 11 verkürzen sich ganz erheblich, wenn die einzelnen Teilkoppelfelder 10, 11 einer Stufe als Druckschaltungsplatte ausgebildet unter Einhaltung eines vorgegebenen Rastermaßes parallel zueinander ausgerichtet werden und die Hauptebenen der aus einer Vielzahl einzelner Teilkoppelfelder 10, 11 bestehenden, als Pakete 27, 28 ausgebildeten Stufen senkrecht zueinander verlaufen. In einem solchen Fall können dann — wie in Fig. 2 dargestellt — sämtliche notwendigen Verbindungen 30 zwischen den zugehörigen Stufen durch Zusammenstecken der beiden Pakete 27, 28 erhalten werden. Das ermöglicht nicht nur eine sehr einfache Verbindung der einzelnen Stufen untereinander, sondern bedingt auch extrem kurze Leitungswege. Bei einem solchen Aufbau sind die Signallaufzeiten auf unterschiedlichen Wegen durch das gesamte Koppelfeld praktisch gleich.

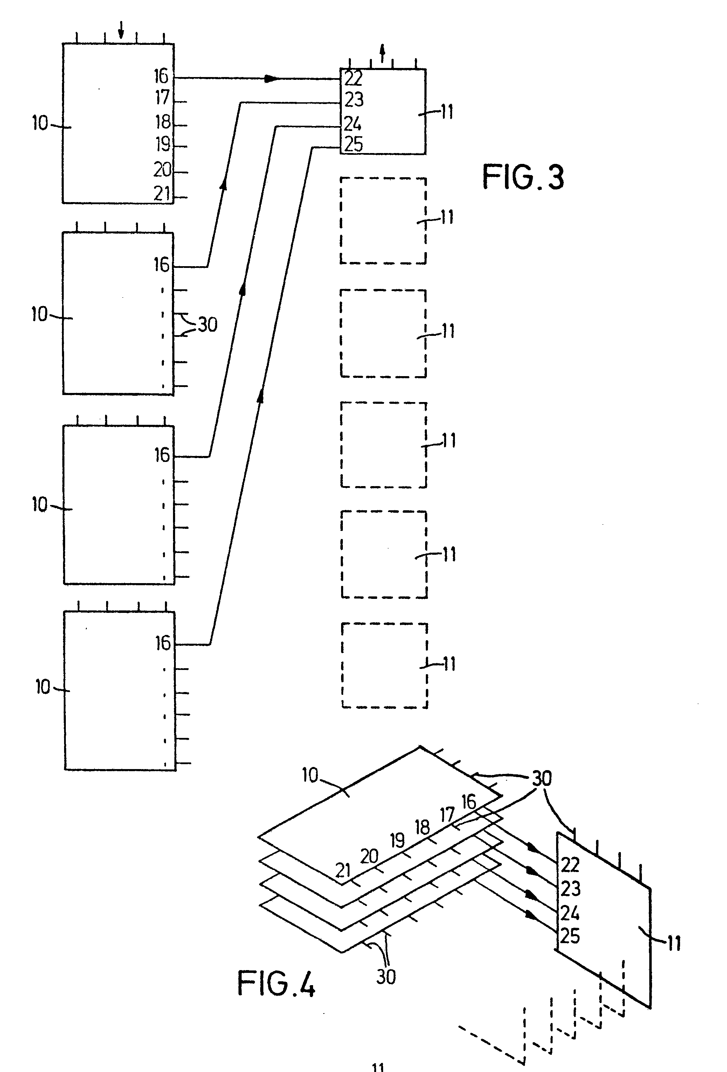

Während die Fig. 1 erkennen läßt, daß sämtliche Ausgänge 16 bis 21 des ersten Teilkoppelfeldes 10 mit dem jeweils ersten Eingang 22 der insgesamt sechs einzelnen Teilkoppelfelder 11 der zweiten Stufe verbunden sind, läßt die schematische Darstellung in Fig. 3 erkennen, daß die jeweils ersten Ausgänge 16 der übrigen Teilkoppelfelder 10 der ersten Stufe jeweils mit dem zweiten, dritten und n-ten Eingang des ersten Teilkoppelfeldes 11 der zweiten Stufe verbunden sind. Die jeweils zweiten Ausgänge 17 der insgesamt vier Teilkoppelfelder 10 der ersten Stufe sind ganz entsprechend mit den vier Eingängen 22 bis 25 des zweiten Teilkoppelfeldes 11 der zweiten Stufe verbunden usw. Fig. 4 läßt die räumliche Zuordnung der vier Teilkoppelfelder 10 der ersten Stufe zu den insgesamt sechs Teilkoppelfeldern 11 der zweiten Stufe erkennen.

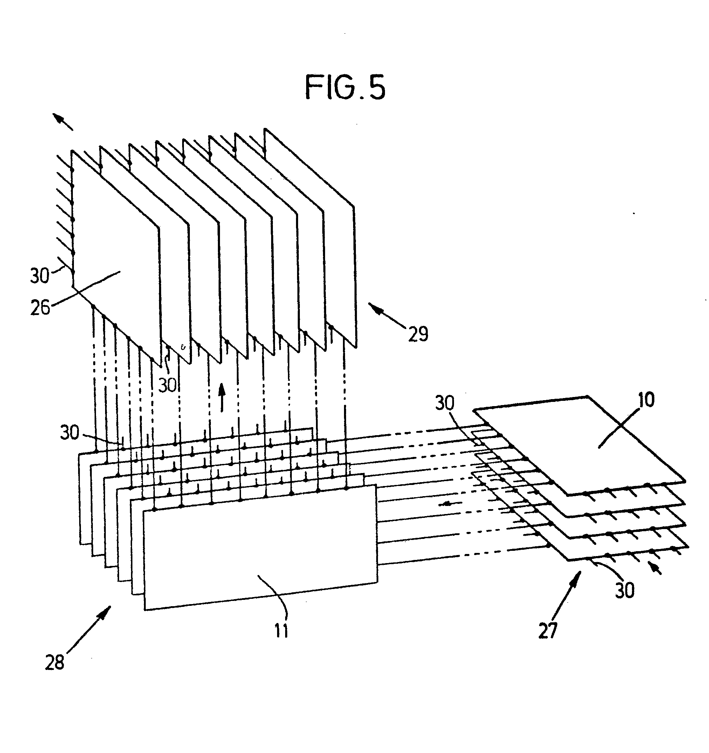

Die Zuordnung der dritten Stufe des Koppelfeldes zur zweiten Stufe ist ganz entsprechend. Fig. 5 läßt erkennen, daß bei einem dreistufigen Koppelfeld drei aus parallel zueinander angeordneten Teilkoppelfeldern 10, 11 und 26 aufgebaute Pakete 27, 28 und 29 vorhanden sind, deren Hauptebenen jeweils senkrecht zur Hauptebene des Pakets der benachbarten Stufe angeordnet ist. Dadurch lassen sich die einzelnen Pakete 27 bis 29 durch Steckverbindungen 30 auf kürzestem Wege miteinander verbinden.

Selbstverständlich kann anstelle des dargestellten dreistufigen Koppelfeldes auch ein aus mehr Stufen bestehendes zur Anwendung kommen.

Die bisher notwendigen Verkabelungen und die daraus resultierenden Kabelbäume sind nicht mehr erforderlich. Die beim Stand der Technik gegebenen Nachteile werden beim beschriebenen Koppelfeld vermieden.

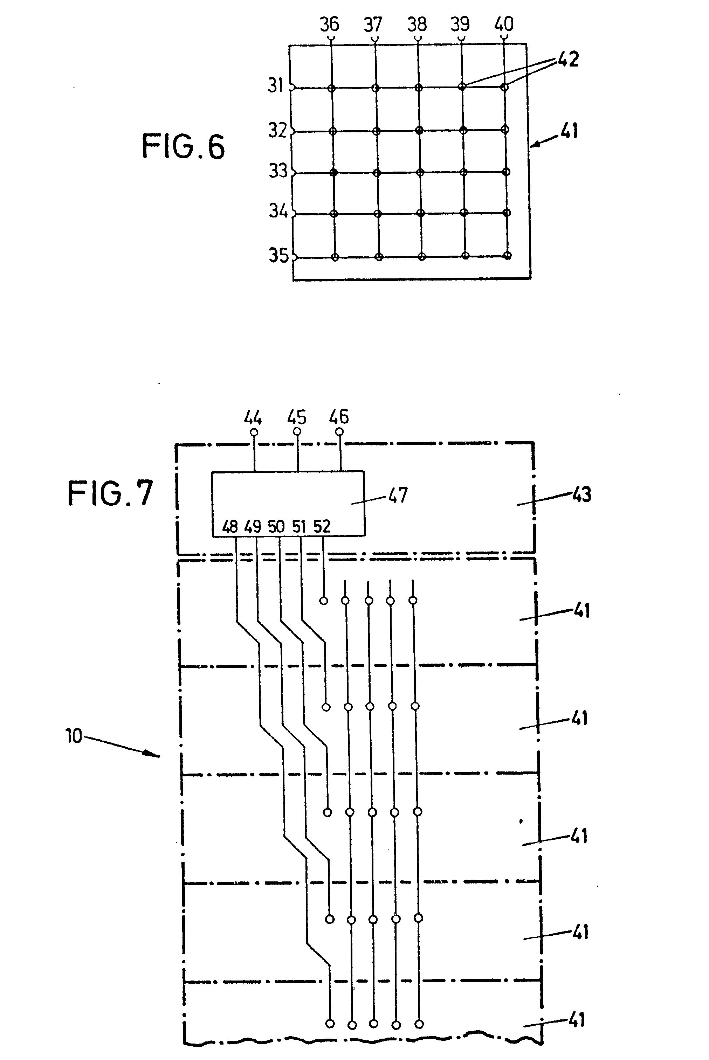

Der in Fig. 6 dargestellte Koppel-Modul 41 weist fünf Eingangssammelleitungen 31 bis 35 und fünf Ausgangssammelleitungen 36 bis 40 auf, die maschenartig einander zugeordnet sind. Die Verbindung einer Eingangssammelleitung 31 bis 35 mit einer beliebigen Ausgangssammelleitung 36 bis 40 erfolgt durch Durchschaltung des zugehörigen Koppelpunktes 42.

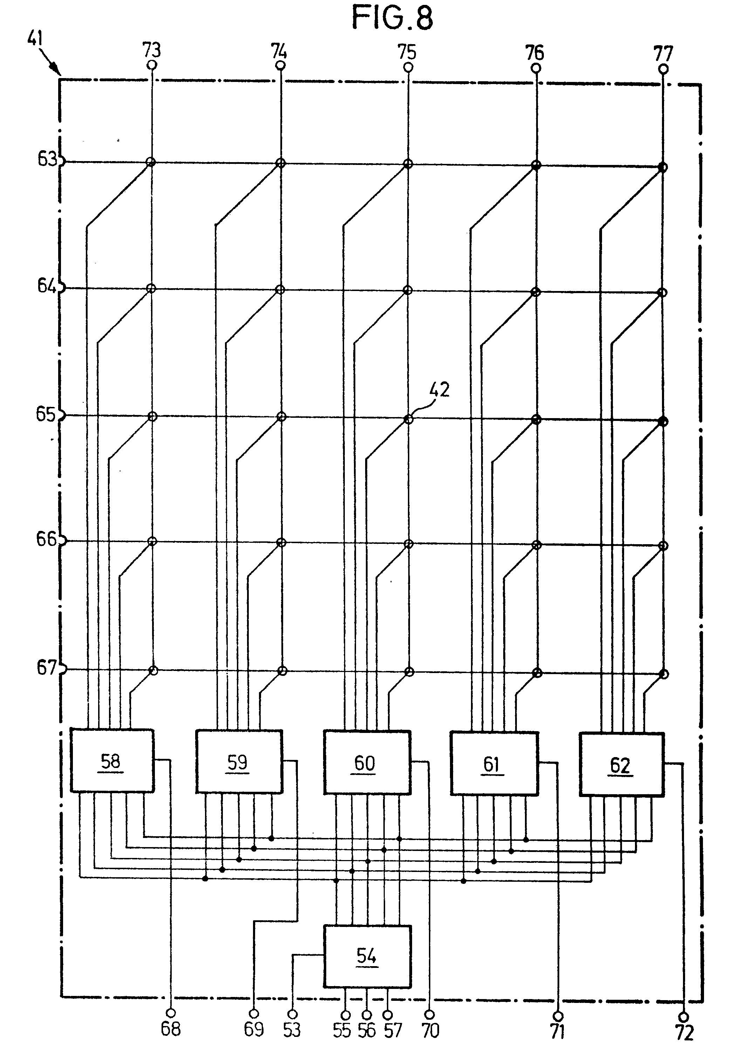

Nachdem ein Teilkoppelfeld 10 aus einer Mehrzahl von Koppelmoduln 41 aufgebaut ist, muß man durch das von einem getrennten Steuermodul 43 kommende Steuersignal zunächst einmal einen bestimmten Koppelmodul 41 ansprechen. Dies geschieht dadurch, daß in Abhängigkeit von dem Signal an Dateneingängen 44 bis 46 eines Modulauswahl-Decoders 47 an einem ganz bestimmten Ausgang 48 bis 52 des Modulauswahl-Decoders 47 ein Ausgangssignal ansteht (Fig. 7). Jeder Ausgang 48 bis 52 des Modulauswahl-Decoders 47 ist mit einem Entriegelungseingang 53 eines auf dem jeweiligen Koppelmodul 41 angeordneten Modul-Decoders 54 verbunden (Fig. 8). Der Modul-Decoder 54 liefert bei Eintreffen von Datensignalen an seinen Dateneingängen 55 bis 57 nur bei Vorhandensein eines Signals an seinem Entriegelungseingang 53 ein Ausgangssignal. Ist diese Voraussetzung gegeben, so wird in Abhängigkeit vom eingehenden binären Datensignal beispielsweise ein Ausgangssignal am dritten Ausgang des Modul-Decoders 54 anstehen. Durch entsprechende Verbindungen ist gewährleistet, daß in einem solchen Fall die zugehörigen — d. h. sämtliche dritten — Eingänge aller auf dem Koppelmodul 41 angeordneten n-fach-D-Flip-Flops 58 bis 62 ein Eingangssignal erhalten. Das bedeutet, daß zunächst einmal sämtliche Koppelpunkte 42 einer Eingangssammelschiene 65 des Koppelmoduls 41 durchgeschaltet werden könnten. Verständlicherweise ist jedoch lediglich die Durchschaltung eines einzigen Koppelpunktes 42 erwünscht. Die Bestimmung desjenigen Koppelpunktes 42 der Eingangssammelleitung 65, der tatsächlich durchgeschaltet wird, wird dadurch festgelegt, daß lediglich eines der fünf n-fach-D-Flip-Flops 58 bis 62 an seinem Clockeingang 68, 69, 70, 71 oder 72 einen Clock-Impuls erhält, der von einem »1 aus n«-Decoder 47 auf dem Steuermodul 43 kommt. Dadurch wird die Ausgangssammelleitung 73 bis 77 festgelegt, die mit der bereits vorher bestimmten Eingangssammelleitung 65 verbunden wird. Enthält beispielsweise der Clock-Eingang 70 einen Impuls, so wird unter den vorher geschilderten Umständen der im Kreuzungspunkt der Eingangssammelleitung 65 und der Ausgangssammelleitung 75 liegende Koppelpunkt 42 durchgeschaltet.

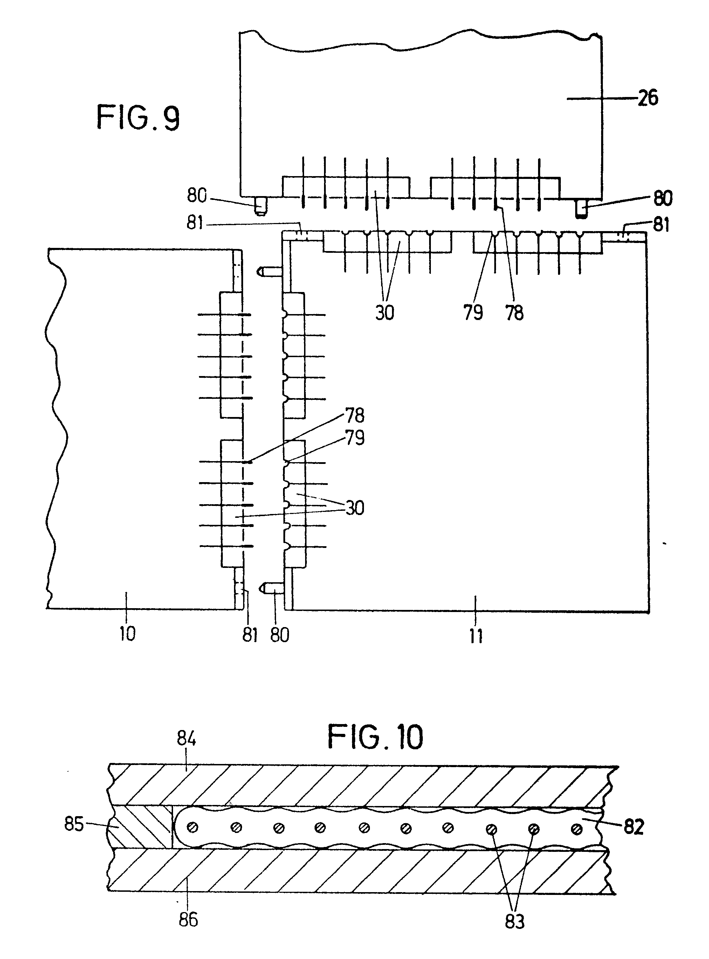

Die Verbindung der Steuer- und Nutzsignalleitungen eines Teilkoppelfeldes 10 mit einem Teilkoppelfeld 11 erfolgt durch Steckverbindungen 30 (Fig. 9). Um bei einer Vielzahl von einzelnen zugehörigen Steckkontakten 78 und 79 trotz der nicht zu vermeidenden Fertigungstoleranzen eine einwandfreie Kontaktierung zu erreichen, ist zumindest eines der Steckverbindungspaare 78, 79 schwimmend — d. h. im hinreichenden Ausmaß auslenkbar — gelagert. So werden die erwähnten Fertigungstoleranzen ausgeglichen. Um in der letzten Phase der Annäherung der beiden durch die Steckverbindung 30 zu verbindenden Teilkoppelfelder 10 und 11 eine gute gegenseitige Ausrichtung zu erreichen, werden die Tafeln der Teilkoppelfelder 10 und 11 zusätzlich mit Fangstiften 80 bzw. zugehörigen Fangbohrungen 81 versehen. In ganz analoger Weise wie die Teilkoppelfelder 10 und 11 miteinander verbunden werden, kann auch das Teilkoppelfeld 26, das gegenüber dem Teilkoppelfeld 10 um 90° verschwenkt angeordnet ist, mit dem Teilkoppelfeld 11 verbunden werden.

Die Verbindung von und zu den Steckverbindungen in den Teilkoppelfeldern 10, 11 und 26 erfolgt über Flachkabel 82, da diese zu einer sehr kompakten Anordnung auf den Teilkoppelfeldern 10, 11 und 26 bzw. auf den Koppelmoduln 41 und dem Steuermodul 43 beitragen (Fig. 10). Dabei könnte sich unter bestimmten Umständen ein Übersprechen zwischen den einzelnen Adern 83 des Flachkabels 82 bemerkbar machen. Dies kann dadurch vermieden werden, daß zwischen den signalführenden Adern 83 einzelne Adern ungenutzt bleiben bzw. mit Masse verbunden werden. Darüber hinaus kann das Flachkabel 82 rundum von leitenden Schichten 84 bis 86 umgeben sein, wobei insbesondere eine Abschirmung nach außen und damit auch gegenüber kreuzenden Flachkabeln 82 erreicht wird.

Ist die Anzahl der Eingangssammelleitungen 63 bis 67 größer als die auf einem Koppelmodul 41 vorhandene Anzahl an Eingangssammelleitungen, so müssen mehrere Koppelmoduln 41 zusammengeschaltet werden. Die Auswahl desjenigen Koppelmoduls 41, auf dem ein Koppelpunkt 42 gesetzt werden soll, erfolgt dann durch einen »1 aus n«-Decoder 47, der auf dem Steuermodul 43 angeordnet ist, wie dies grundsätzlich bereits im Zusammenhang mit der Fig. 7 beschrieben wurde.

Wenn die Anzahl der Ausgangssammelleitungen größer ist als die auf einem Koppelmodul 41 vorhandene Anzahl, so können in ganz analoger Weise ebenfalls mehrere Koppelmoduln 41 zusammengeschaltet und wie oben geschildert angesteuert werden.

Selbstverständlich könnte anstelle der oben geschilderten Flachkabel 82 bei entsprechend großen Stückzahlen auch eine Druckschaltungsplatte mit einer entsprechenden gedruckten Schaltung verwendet werden.

Die Verbindung der Flachkabel 82 mit den Steckverbindungen 30 sowie der Flachkabel 82 untereinander erfolgt vorteilhafterweise in Schneid-Klemm-Technik (Anschlagtechnik), wodurch eine Vielzahl von Verbindungen in einem einzigen Arbeitsgang erreicht werden kann. Damit erübrigen sich die bisher üblichen Lötverbindungen.

Die Steuermoduln 43 können zusätzlich pro Ausgangssammelleitung einen Trennverstärker und einen besonderen Koppelpunkt tragen. Über diesen kann durch eine zusätzliche Sammelleitung (Prüfachse) jeweils ein Ausgangssignal des Teilkoppelfeldes für Prüfzwecke an einen Prüfausgang geführt werden. Die Steuerung erfolgt dabei so, daß niemals mehr als ein Prüfachsenkoppelpunkt gleichzeitig eingeschaltet werden kann.

Die Moduln enthalten dabei Bauteile zur Daten- Pufferung.

**Patentansprüche**

1. Mehrstufiges Koppelfeld, insbesondere zur Verkopplung höherfrequenter Signalquellen und -senken, bei dem die einzelnen Stufen aus einer Mehrzahl von aus Druckschaltungsplatten gebildeten Teilkoppelfeldern (10, 11, 26) bestehen, wobei die Anzahl der Ausgänge (16 bis 21) eines Teilkoppelfeldes einer Stufe gleich der Anzahl der Teilkoppelfelder der nachfolgenden Stufe und die Anzahl der Eingänge (12 bis 15; 22 bis 25) eines Teilkoppelfeldes gleich der Anzahl der Teilkoppelfelder der vorangehenden Stufe ist, und wobei die einzelnen Teilkoppelfelder (10, 11, 26) einer Stufe unter Einhaltung eines vorgegebenen Rastermaßes derart parallel zueinander ausgerichtet sind, daß sie ein mehrschichtiges Paket (27, 28, 29) bilden und die in einer Ebene liegenden Ausgänge des Pakets einer vorausgehenden Stufe durch Steckverbindungen (30) direkt mit den ebenfalls in einer Ebene liegenden Eingängen des Pakets der nachfolgenden Stufe derart verbindbar sind, daß die Hauptebenen zweier benachbarter Pakete (27, 28, 29) senkrecht zueinander verlaufen, dadurch gekennzeichnet, daß

- sämtliche Eingänge (22 bis 25) in einer ersten Begrenzungsfläche des Pakets (27, 28, 29) und sämtliche Ausgänge (16 bis 21) in einer zweiten, zur ersten senkrecht liegenden Begrenzungsfläche des Pakets (27, 28, 29) angeordnet sind,
- die Verbindung der Steuer- und Nutzsignalleitungen der einzelnen Teilkoppelfelder (10, 11, 26) untereinander durch Steckverbindungen (30) erfolgt, wobei mindestens ein Teil des Steckverbindungspaares (78, 79) schwimmend — d. h. in hinreichendem Ausmaß auslenkbar — gelagert ist,
- zum erleichterten Ausrichten der Teilkoppelfelder (10, 11, 26) beim Zusammenfügen der Steckverbindungen zusätzlich Fangstifte (80) und zugehörige Fangbohrungen (81) an den Teilkoppelfeldern (10, 11, 26) vorhanden sind,
- Flachkabel (82) für die Steuer- und Nutzsignalleitungen von und zu den Steckverbindungen in den Teilkoppelfeldern (10, 11, 26) durch mindestens eine leitende Schicht (84, 85, 86), beispielsweise durch eine Metallfolie, abgeschirmt sind und
- einzelne Adern (83) der Flachkabel (82) zur Verminderung des Übersprechens ungenutzt bzw. an Masse gelegt sind.

2. Koppelfeld nach Anspruch 1, dadurch gekennzeichnet, daß die einzelnen Teilkoppelfelder (10, 11, 26) in sich zweidimensional modular aufgebaut sind.

3. Koppelfeld nach Anspruch 2, dadurch gekennzeichnet, daß die jeweils benötigten Teilkoppelfelder (10, 11, 26) durch Hinzufügen oder Abtrennen einzelner Moduln dimensionierbar sind.

4. Koppelfeld nach einem der Ansprüche 1 bis 3, dadurch gekennzeichnet, daß sämtliche Teilkoppelfelder (10, 11, 26) einer Stufe untereinander gleich sind.

5. Koppelfeld nach einem der Ansprüche 1 bis 4, dadurch gekennzeichnet, daß die Teilkoppelfelder (10, 11, 26) sämtlicher Stufen grundsätzlich den gleichen modularen Aufbau haben.

6. Koppelfeld nach einem der Ansprüche 1 bis 5, dadurch gekennzeichnet, daß die einzelnen Teilkoppelfelder (10, 11, 26) in Form von Druckschaltungsplatten nebeneinander angeordnet und austauschbar sind.

7. Koppelfeld nach einem der Ansprüche 1 bis 6, dadurch gekennzeichnet, daß die Teilkoppelfelder (10, 11, 26) die Gestalt von rechteckigen Druckschaltungstafeln haben, die an zwei zueinander im rechten Winkel stehenden Seiten Steckverbindungen (30) sowohl für den Nutz- als auch für die Steuersignale aufweisen.

8. Koppelfeld nach einem der Ansprüche 1 bis 7, dadurch gekennzeichnet, daß es durch digitalcodierte Steuersignale durchschaltbar ist.

9. Koppelfeld nach einem der Ansprüche 2 bis 8, dadurch gekennzeichnet, daß auch die für die Steuerung der Koppelpunkte erforderlichen Schaltkreise auf den Moduln angeordnet sind.

10. Koppelfeld nach einem der Ansprüche 1 bis 9, dadurch gekennzeichnet, daß auf jedem Teilkoppelfeld (10, 11, 26) mindestens ein Steuermodul (43) vorhanden ist, der mindestens einen Modulauswahl-Decoder »1 aus n« (47) mit Dateneingängen (44, 45, 46) und Steuersignalausgängen (48 bis 52) aufweist und dessen einzelne Ausgänge (48 bis 52) jeweils mit einem Entriegelungseingang (53) eines Modul-Decoders »1 aus n« (54) auf dem einzelnen Modul (43) des Teilkoppelfeldes (10, 11, 26) verbunden ist.

11. Koppelfeld nach Anspruch 10, dadurch gekennzeichnet, daß die einzelnen Modul-Decoder »1 aus n« (54) neben dem erwähnten Entriegelungseingang (53) mehrere Dateneingänge (55, 56, 57) aufweisen, die derart mit den Entriegelungseingängen (53) verbunden sind, daß der Decoder (54) nur im entriegelten Zustand bei Eintreffen eines Datensignals ein Signal an einem bestimmten Ausgang aufweist.

12. Koppelfeld nach Anspruch 11, dadurch gekennzeichnet, daß das Signal des bestimmten n-ten Ausgangs des Modul-Decoders (54) gleichzeitig allen n-ten Eingängen einer Vielzahl von n-fach-Leitungsanwahl-Flip-Flops (58 bis 62) zuführbar ist, wobei die entsprechenden Leitungsanwahl-Flip-Flops (58 bis 62) jedoch nur bei Vorhandensein eines der Auswahl der einzelnen Flip-Flops (58 bis 62) dienenden Clock-Impulses die zugehörigen Koppelpunkte (42) des Koppelfeldmoduls (41) ansteuerndes Ausgangssignal liefern.

13. Koppelfeld nach einem der Ansprüche 1 bis 12, dadurch gekennzeichnet, daß die Verbindung der einzelnen Flachkabel (82) untereinander bzw. mit den Steckverbindungselementen durch an sich bekannte Schneid-Klemm-Elemente (Anschlagtechnik) erfolgt.

## Claims

1. A multi-stage switching array, particularly for coupling together higher-frequency signal sources and sinks, in which array the individual stages consist of a plurality of partial switching arrays (10, 11, 26) formed by printed circuit boards, the number of outputs (16 to 21) of one partial switching array of one stage being identical to the number of partial switching arrays of the following stage and the number of inputs (12 to 15; 22 to 25) of one partial switching array being identical to the number of partial switching arrays of the preceding stage, and the individual partial switching arrays (10, 11, 26) of one stage being aligned, maintaining a predetermined modular dimension, in parallel with one another in such a manner that they form a multilayer parcel (27, 28, 23) and the outputs, located in one plane, of the parcel of a preceding stage being connectable by plug connections (30) directly to the inputs, also located in one plane, of the parcel of the subsequent stage in such a manner that the main planes of two adjacent parcels (27, 28, 29) are arranged at right angles to one another, characterised in that

— all inputs (22 to 25) are arranged in a first boundary surface of the parcel (27, 28, 29) and all outputs (16 to 21) are arranged in a second boundary surface which is located at right angles to the first boundary surface of the parcel (27, 28, 29),
— the control and useful-signal lines of the individual partial switching arrays (10, 11, 26) are connected to each other by plug connections (30), at least a part of the plug connection pair (78, 79) being supported to be floating — that is to say deflectable to an adequate extent,
— additionally, capture pins (80) and associated capture holes (81) are provided at the partial switching arrays (10, 11, 26) in order to facilitate the alignment of the partial switching arrays (10, 11, 26) when joining the plug connections together,
— ribbon cables (82) for the control and useful-signal lines from and to the plug connections in the partial switching arrays (10, 11, 26) are screened by at least one conductive layer (84, 85, 86), for example by a metal foil, and
— individual cores (83) of the ribbon cables (82) are unused or cennected to earth, respectively, in order to reduce cross-talk.

2. A switching array according to claim 1, characterised in that the individual partial switching arrays (10, 11, 26) are in themselves of a two-dimensional modular construction.

3. A switching array according to claim 2, characterised in that the partial switching arrays (10, 11, 26) needed in each case can be provided with the required dimensions by adding or removing individual modules.

4. A switching array according to one of claims 1 to 3, characterised in that all partial switching arrays (10, 11, 26) of one stage are identical with respect to each other.

5. A switching array according to one of claims 1 to 4, characterised in that, fundamentally, the partial switching arrays (10, 11, 26) of all stages have the same modular construction.

6. A switching array according to one of claims 1 to 5, characterised in that the individual partial switching arrays (10, 11, 26) are arranged next to each other in the form of printed circuit boards and are interchangeable.

7. A switching array according to one of claims 1 to 6, characterised in that the partial switching arrays (10, 11, 26) have the form of rectangular printed circuit panels, which, at two sides being at right angles to each other, are provided with plug connections (30) both for the useful and for the control signals.

8. A switching array according to one of claims 1 to 7, characterised in that signals can be switched through the switching array by means of digitally coded control signals.

9. A switching array according to one of claims 2 to 8, characterised in that the circuits required for controlling the switching points are also arranged on the modules.

10. A switching array according to one of claims 1 to 9, characterised in that in each partial switching array (10, 11, 26) at least one control module (43) exists which is provided with at least one »1-off-n« module selection decoder (47) having data inputs (44, 45, 46) and control signal outputs (48 bis 52) and whose individual outputs (48 to 52) are connected in each case to an enabling input (53) of an »1-off-n« module decoder (54) in the individual module (43) of the partial switching array (10, 11, 26).

11. A switching array according to claim 10, characterised in that the individual »1-off-n« module decoders (54), apart from the abovementioned enabling input (53), are provided with serveral date inputs (55, 56, 57) which are connected to the enabling inputs (53) in such a manner that the decoder (54) has a signal at a certain output only if the decoder is enabled during the arrival of a data signal.

12. A switching array according to claim 11, characterised in that the signal of the certain nth output of the module decocer (54) can be simultaneously fed to all nth inputs of a plurality of n-times line selection flip flops (58 to 62), in which arrangement the respective line selection flip flops (58 to 62), however, supply an output signal which drives the associated switching points (42) of the switching array module (41) only if a clock pulse is present which is used for selecting the individual flip flops (58 to 62).

13. A switching array according to one of claims 1 to 12, characterised in that the individual ribbon cables (82) are connected to each other or to the plug connection elements, respectively, by means of cutting-clamping elements (insert-to-stop technique) known in themselves.

**Revendications**

1. Réseau de couplage à plusieurs étages, en particulier pour coupler des sources et des charges de signaux à haute fréquence, dans lequel les différents étages sont composés d'une pluralité de réseaux de couplage partiels (10, 11, 26) formés par des panneaux de circuits imprimés, le nombre des sorties (16 à 21) d'une réseau de couplage partiel d'un étage étant égal au nombre des réseaux de couplage partiels de l'étage suivant et le nombre des entrées (12 à 15; 22 à 15) d'un réseau de couplage partiel étant égal au nombre des réseaux de couplage partiels de l'étage précédent, les différents réseaux de couplage partiels (10, 11, 26) d'un étage étant alignés les uns sur les autres parallèlement, en conservant une maille de réseau prédéterminée, de manière qu'ils forment un paquet à plusieurs couches (27, 28, 29) et que les sorties du paquet d'un étage précédent qui se trouvent dans un même plan puissent être reliées directement, par des connexions à broches (30), aux entrées du paquet de l'étage suivant se trouvant également dans un même plan, de telle manière que les plans principaux de deux paquets voisins (27, 28, 29) s'étendent perpendiculairement entre eux, caractérisé en ce que:

— toutes les entrées (22 à 25) sont disposées dans une première surface limite du paquet (27, 28, 29) et toutes les sorties (16 à 21) sont disposées dans une deuxième surface limite du paquet (27, 28, 29) qui s'étend perpendiculairement à la première,

— la liaison entre les lignes de signaux de commande et de signaux utiles des différents réseaux de couplage partiels (10, 11, 26) entre eux s'effectuent par des connexions à broches (30), au moins une partie de la paire de connexions à broche (78, 79) étant montée flottante, c'est-à-dire capable de dévier dans une mesure suffisante,

— pour faciliter l'alignement des réseaux de couplage partiels (10, 11, 26) lors de l'assemblage des connexions à broche, il est prévu en supplément des doigts de retenue (80) et des perçages de retenue correspondants (81) sur les réseaux de couplage partiels (10, 11, 26),

— des câbles plats (82) pour les lignes de signaux de commande et de signaux utiles, provemant des connexions à broches prévues dans les réseaux de couplage partiels (10, 11, 26) ou aboutissant à des connexions à broches sont blindés par au moins une couche conductrice (84, 85, 86), par exemple par une pellicule métallique, et

— différentes âmes (83) du câble plat (82) sont laissées inutilisées ou mises à la masse pour réduire la diaphonie.

2. Réseau de couplage selon la revendication 1, caractérisé en ce que les différents réseaux de couplage partiels (10, 11, 26) sont montés modulaires en deux dimensions.

3. Réseau de couplage selon la revendication 2, caractérisé en ce que les réseaux de couplage partiels utilisés (10, 11, 26) peuvent être dimensionnés par addition ou soustraction de modules élémentaires.

4. Réseau de couplage selon l'une des revendications 1 à 3, caractérisé en ce que tous les réseaux de couplage partiels (10, 11, 26) d'un étage sont indentiques entre eux.

5. Réseau de couplage selon l'une des revendications 1 à 4, caractérisé en ce que les réseaux de couplage partiels (10, 11, 26) de tous les étages ont essentiellement la même construction modulaire.

6. Réseau de couplage partiel selon l'une des revendications 1 à 5, caractérisé en ce que les réseaux de couplage partiels individuels (10, 11, 26), se présentant sous la forme de circuits imprimés, sont disposés l'un à côté de l'autre et interchangeables.

7. Réseau de couplage selon l'une des revendications 1 à 6, caractérisé en ce que les réseaux de couplage partiels (10, 11, 26) ont la forme de panneaux de circuits imprimés rectangulaires qui présentent, sur deux côtés perpendiculaires entre eux, des connexions à broches (30), aussi bien pour les signaux utiles que pour les signaux de commande.

8. Réseau de couplage selon l'une des revendications 1 à 7, caractérisé en ce qu'il peut être commuté par des signaux de commande codés en numérique.

9. Réseau de couplage selon l'une des revendications 2 à 8, caractérisé en ce que les circuits nécessaires pour la commande des points de couplage sont également disposés sur les modules.

10. Réseau de couplage selon l'une des revendications 1 à 9, caractérisé en ce que, sur chaque réseau de couplage partiel (10, 11, 26) est prévu au moins un module de commande (43) qui présente au moins un décodeur sélecteur de module »1 dans n« (47) muni d'entrées de données (44, 45, 46) et de sorties de signaux de commande (48 à 52) et dont les différentes sorties (48 à 52) sont reliées chacune à une entrée de déverouillage (53) d'un décodeur de module »1 dans n« (54) sur le module individuel (43) du réseau de couplage partiel (10, 11, 26).

11. Réseau de couplage selon la revendication 10, caractérisé en ce que les différents décodeurs de module »1 dans n« (54) présentent, en supplément de l'entrée de déverrouillage précitée (53), plusieurs entrées de donnés (55, 56, 57) qui sont reliées aux entrées de déverrouillage (53) de telle manière que ce n'est que dans l'état déverrouillé que le décodeur présente un signal à une sortie déterminée au moment de l'arrivée d'un signal de données.

12. Réseau de couplage selon la revendication 11, caractérisé en ce que le signal de la n-ième sortie déterminée du décodeur de module (54) peut être acheminée simultannément à toutes les n-ièmes entrées d'un grand nombre de bascules (58 à 62) à n choix de conducteur, les bascules à choix de conducteur (58 à 62) correspondantes ne fournissant toutefois le signal de sortie commandant les points de couplage correspondants (42) du module réseau de couplage (41) qu'en présence d'une impulsion d'horloge servant pour la sélection des différentes bascules (58 à 62).

13. Réseau de couplage selon l'une des revendications 1 à 12, caractérisé en ce que la connexion des différentes câbles plats (82) entre eux ou avec les éléments de connexion à broches est assurée par des éléments de coupe-serrage connus en soi (technique de butée).

**0 037 882**

FIG.1

FIG.2

FIG.3

FIG.4

# FIG.5

## FIG.6

## FIG.7

# FIG.8

FIG.9

26

80

80

81

81

30

79  78

78

79

30

10

81  80

11

FIG.10

84

85

82

86

83